# EUROPÄISCHE PATENTSCHRIFT

(11) **EP 3 104 418 B1**
(45) Veröffentlichungstag und Bekanntmachung des Hinweises auf die Patenterteilung: **14.02.2018**
(21) Anmeldenummer: 15170950.8
(22) Anmeldetag: 08.06.2015
(51) Int. Cl.: H01L 31/0236, H01L 31/068, H01L 21/3065

(54) **VERFAHREN UND VORRICHTUNG ZUM TEXTURIEREN EINER SILIZIUMOBERFLÄCHE**
METHOD AND DEVICE FOR TEXTURING A SILICON SURFACE
PROCÉDÉ ET DISPOSITIF DESTINÉS À TEXTURER UNE SURFACE EN SILICIUM

(43) Veröffentlichungstag der Anmeldung: 14.12.2016
(73) Patentinhaber: Meyer Burger (Germany) AG, 09337 Hohenstein-Ernstthal (DE)
(72) Erfinder: Uhlig, Matthias, 09385 Lugau (DE)
(74) Vertreter: Steiniger, Carmen

(56) Entgegenhaltungen:
- WO-A1-2007/049347
- WO-A1-2012/145473
- US-A1- 2013 069 204

## Beschreibung

Die vorliegende Erfindung betrifft ein Verfahren zum Texturieren wenigstens einer Substratoberfläche wenigstens eines kristallinen Siliziumsubstrates durch Ätzen der Substratoberfläche mit Fluorgas, wobei das Ätzen des Siliziumsubstrates in einem Plasma vorgenommen wird, das in einem Plasmaätzraum erzeugt wird. Weiterhin betrifft die vorliegende Erfindung eine Vorrichtung zum Texturieren wenigstens einer Substratoberfläche wenigstens eines kristallinen Siliziumsubstrates mit einem Plasmaätzraum, der eine Gaszuführeinrichtung, die mit einer Fluorquelle gekoppelt ist, und wenigstens eine Plasmaquelle aufweist.

Texturieren bedeutet in diesem Zusammenhang eine Erzeugung einer hohen, aber gleichmäßigen Oberflächenrauhigkeit der Substratoberfläche im Mikrometer- und Submikrometerbereich. Eine derart texturierte Oberfläche absorbiert mehr und reflektiert weniger elektromagnetische Strahlung als eine glatte Oberfläche. Eine derartige Texturierung wird daher bei Oberflächen vorgenommen, bei welchen elektromagnetische Strahlung mit der Materie unter der Oberfläche wechselwirken soll, beispielsweise bei einer photovoltaischen Zelle. Wird eine Oberfläche dieser Zelle texturiert, so wird weniger Licht reflektiert, und der Wirkungsgrad der photovoltaischen Zelle steigt im Vergleich zu einer Zelle, deren Oberfläche nicht texturiert ist. Für das Texturieren kommen vorwiegend fluorhaltige Chemikalien zum Einsatz, um Silizium und beispielsweise Siliziumoxid unter anderem zu flüchtigem Siliziumtetrafluorid umzusetzen. Aufgrund der hohen Reaktivität und den damit verbundenen hohen Sicherheitsanforderungen bezüglich des Fluorgases ist dessen industrielle Verwendung als Prozessgas strengen Auflagen unterworfen. Insbesondere ein Transport von Fluorgas ist stark limitiert. Häufig werden daher zum Texturieren von Siliziumsubstraten fluorhaltige Prozessgase, etwa Schwefelhexafluorid, Stickstofftrifluorid oder Tetrafluormethan, verwendet.

Ein eingangs genanntes Verfahren sowie eine eingangs genannte Vorrichtung sind aus der Druckschrift WO 2009/092453 A2 bekannt. In dieser ist ein Plasmaätzprozess für Siliziumoberflächen offenbart, welcher mit Fluorgas, Carbonylfluorid oder Stickstofftrifluorid oder einer Mischung aus diesen ausführbar ist. Außerdem wird vorgeschlagen, zusätzlich beispielsweise Schwefelhexafluorid dem Ätzgas beizumischen. Die Verwendung von Schwefelhexafluorid und Stickstofftrifluorid ist aufgrund deren Wirkung als Treibhausgas von Nachteil.

In der Druckschrift WO 2012/145473 A1 ist ein Trockenätzverfahren mit Fluorgas für das Ätzen und Texturieren einer Siliziumwaferoberfläche offenbart. Dabei werden bei einer Temperatur von 450 bis 550 °C und einem Druck von 10 bis 50 Torr in einem Zeitraum von 30 bis 90 Sekunden 7 bis 20 µm der Oberfläche des Siliziumwafers entfernt, wobei Sägeschäden abgetragen werden und eine Texturierung der Oberfläche vorgenommen wird. Hierbei entsteht eine sogenannte "dark texture", die noch effektiver Licht absorbiert, als dies bei durch nasschemische Tauchverfahren erzeugten Texturen möglich ist. Aufgrund der hohen Ätzrate ist der beschriebene Prozess nur schlecht kontrollierbar.

Ein anderes bekanntes Verfahren ist in der Druckschrift US 2013/0069204 A1 beschrieben. Dort wird Fluorgas oder fluoridhaltiges Gas, wie Tetrafluormethan, Trifluormethan, Carbonylfluorid, Schwefelhexafluorid, Stickstofftrifluorid oder Xenondifluorid, in einem Gemisch mit einer chlorhaltigen Verbindung zum Ätzen und Strukturieren einer Oberfläche eines Siliziumwafers bei Temperaturen von mehr als 450 °C genutzt. Als chlorhaltige Verbindungen kommen Tetrachlormethan, Trichlorsilan mit Wasserstoff oder Chlorwasserstoff zum Einsatz. Die in diesem Verfahren entstehenden sowohl fluor- als auch chlorhaltigen Prozessabgase sind nur unter großem technischen Aufwand entsorgbar.

In der Druckschrift US 8,952,949 B2 ist ein Plasmaätzverfahren zur Texturierung einer Siliziumoberfläche offenbart, in dem ein Gemisch aus Schwefelhexafluorid und Sauerstoff in einem Hochfrequenzplasma eingesetzt wird. Auch in diesem Fall ist die Verwendung von Schwefelhexafluorid aufgrund des starken Treibhauseffektes ungünstig.

Außerdem wird in der Druckschrift US 2014/0216541 A1 ein mehrstufiges Verfahren zur Texturierung einer Siliziumoberfläche vorgeschlagen, bei dem zunächst ein nasschemischer, basischer Ätzprozess zur Erzeugung einer von Pyramiden geprägten Oberfläche erfolgt. Anschließend wird eine weitere Feintexturierung durch trockenes Ätzen mit Chlortrifluorid durchgeführt. Derartige mehrstufige Verfahren sind zeit- und materialintensiv, da nach dem nasschemischen Prozessschritt eine aufwändige Trocknung erfolgen muss, um Störungen beim Trockenätzprozess zu vermeiden. Weiterhin sind hier die Entstehung von umfangreichen chemischen Abfällen sowie die lange Prozessdauer von Nachteil.

Es ist daher die Aufgabe der vorliegenden Erfindung, ein Verfahren und eine Vorrichtung zum Texturieren einer Siliziumoberfläche vorzuschlagen, bei welchen material- und umweltschonend eine hochqualitative Texturierung von Siliziumoberflächen möglich ist.

Die Aufgabe wird durch ein Verfahren der oben genannten Gattung gelöst, bei welchem dem Plasmaätzraum neben Fluorgas wenigstens gasförmiges Schwefeloxid zugeführt wird. Als Schwefeloxid sind hierbei und im Folgenden Verbindungen der allgemeinen Summenformel SₓO_{y} bezeichnet, also beispielsweise Dischwefelmonoxid, Schwefelmonoxid, Schwefeldioxid, Dischwefeldioxid und/oder Schwefeltrioxid.

Die Verwendung von Fluorgas in einem Plasma ist vorteilhaft, da die Reaktionschemie in dem fluorbasierten Plasmaprozess über einen weiten Bereich einstellbar ist. Im Stand der Technik bekannte Verfahren führen je nach Prozessparametern entweder zu glatten Substratoberflächen, welche sehr hohe Reflektivitäten aufweisen oder aber zu sogenannten "dark textures", welche zwar sehr wenig elektromagnetische Strahlung reflektieren, aber auch einen Großteil der Strahlung innerhalb der texturierten Oberfläche absorbieren, anstatt diese zu einem Bulk-Bereich des Substrates beziehungsweise einen in dem Siliziumsubstrat befindlichen pn-Übergang zu leiten. Außerdem sind "dark textures" sehr fragil und daher schwer in einem Beschichtungsprozess zu passivieren. Damit sind die so texturierten Substratoberflächen für die Verwendung in beispielsweise Solarzellen ungeeignet. Für das erfindungsgemäße Verfahren hat sich überraschenderweise eine besonders vorteilhafte Texturierung der Substratoberfläche ergeben, wenn dem Fluorgas im Plasmaätzraum Schwefeloxid, SₓO_{y}, zugeführt wird.

Erfindungsgemäß wird also gasförmiges Schwefeloxid neben Fluorgas für einen Plasmaätzprozess zum Texturieren von Siliziumoberflächen eingesetzt, es wird somit ein plasmaangeregter chemischer Ätzprozess von Siliziumoberflächen verwirklicht. Die Anwendung des besagten Plasmas führt zur Bildung von Radikalen und reaktiven Ionen sowie Atomen und Molekülen in angeregten Zuständen, welche mit der Siliziumoberfläche sowie mit eventuell vorhandenem Luftoxid, das heißt an der Substratoberfläche befindlichem Siliziumoxid, oder zusätzlich dem Prozessgas zugesetzten sauerstoffhaltigen Verbindungen, wie z. B. O₂ oder N₂O, reagieren können. Dies ermöglicht die Bearbeitung von unterschiedlichsten Siliziumsubstraten, da der Prozess im Gegensatz zu rein physikalischen und rein chemischen Abtrageverfahren somit unabhängig von beispielsweise kristallografischen Eigenschaften der zu behandelnden Substratoberfläche oder vom eingesetzten Substratherstellungsverfahren ist. Damit sind also beispielsweise sowohl von Diamantdraht gesägte Wafer texturierbar wie auch sehr dünne Siliziumsubstrate. Dahingegen werden beim reaktiven lonenätzen, auch "reactive ion etching" oder RIE genannt, die Radikale und reaktiven Ionen sowie Atome und Moleküle in angeregten Zuständen durch ein Potentialgefälle zur Substratoberfläche hin beschleunigt, wodurch diese Teilchen mit hoher Geschwindigkeit auf der Substratoberfläche aufschlagen und physikalisch Atome aus der Substratoberfläche herausschlagen. Dadurch können Verspannungen im Kristall des Siliziumsubstrates hervorgerufen werden. Dies wird beim erfindungsgemäßen Verfahren vermieden.

Im Gegensatz zu nasschemischen Texturierverfahren ist mit dem erfindungsgemäßen Verfahren auch ein Einseitenprozess realisierbar, welcher ein Siliziumsubstrat nur an einer gewünschten Oberfläche texturiert. Somit werden durch dieses Verfahren weniger Chemikalien verbraucht als in einem nasschemischen Texturierprozess. Es muss kein deionisiertes Wasser, was bei nasschemischen Ätzverfahren zur Substratspülung eingesetzt wird, aufbereitet werden. Zudem entfällt bei der vorliegenden Erfindung eine nachträgliche Politur der Rückseite der Siliziumsubstrate, wie sie bei verschiedenen Herstellungstechnologien, speziell für hocheffiziente Solarzellen notwendig oder zumindest vorteilhaft ist. Bei nasschemischen Verfahren liegen die entstehenden Abprodukte in Lösung vor und verweilen somit lange in der Nähe der Substratoberfläche. Die steigende Konzentration der Produkte sowie die sinkende Konzentration der Ätzreagenzien im Ätzbad während der Prozessdauer führen zu einer Verlangsamung des Texturierungsprozesses, wodurch bei nasschemischen Verfahren die eingesetzten Ätzbäder regelmäßig getauscht oder zumindest nachdosiert werden müssen und ein hoher Aufwand für die Wiederaufbereitung der gebrauchten Ätzbäder betrieben werden muss. Dagegen sind bei dem erfindungsgemäßen Verfahren die entstehenden Abprodukte gasförmig und werden im Prozess zügig durch einen Gasauslass von der Substratoberfläche entfernt. Gleichzeitig können stetig neue Ätz-, Prozess- und Hilfsgase dem Plasmaätzraum zugeführt werden. Somit ist einerseits die Reaktionsgeschwindigkeit des erfindungsgemäßen Texturierverfahrens unabhängig von der Prozessdauer und andererseits entstehen viel weniger aufzubereitende Abfälle als bei nasschemischen Texturierverfahren. Eine Akkumulation von Verunreinigungen im Prozessraum ist zudem bei der vorliegenden Erfindung stark reduziert.

Bei dem erfindungsgemäßen Verfahren kommen zudem Gase zum Einsatz, welche einen sehr geringen oder keinen Treibhauseffekt aufweisen und sich auf einfache Weise aus den Prozessabgasen abtrennen lassen. Die bei dem erfindungsgemäßen Verfahren auszuscheidenden Abgase, wie beispielsweise Siliziumtetrafluorid, Fluorgas, Sauerstoffdifluorid oder Fluorwasserstoff, sind umweltneutral oder aber zumindest neutral in Hinsicht auf die Klimaerwärmung. Darüber hinaus eröffnet das erfindungsgemäße Verfahren die Möglichkeit, nur sehr wenige bis gar keine umweltschädlichen Abgase in die Umwelt zu entlassen. Außerdem wird erfindungsgemäß der Einsatz von Chemikalien auch gegenüber Verfahren, welche andere Prozessgase nutzen, wesentlich verringert, da beispielsweise die Atomeffizienz des eingesetzten Fluorgases für dieses Verfahren etwa 80 % bis 90 % beträgt.

In einer Weiterbildung des erfindungsgemäßen Verfahrens ist vorgesehen, dass das Fluorgas in wenigstens einem mit dem Plasmaätzraum gekoppelten Fluorgaserzeugungssystem mittels Elektrolyse erzeugt und dem Plasmaätzraum zugeführt wird. Somit ist eine Produktion des Fluorgases am Ort des Plasmaätzprozesses vorgesehen, wodurch einerseits der Transport von Fluor entfällt und andererseits das Fluorgas entsprechend den Prozessanforderungen stets in den benötigten Mengen zur Verfügung gestellt werden kann. Als Ausgangsstoff für die Fluorherstellung in dem Fluorgaserzeugungssystem dient dabei Fluorwasserstoff, welcher sicher und vor allem verlustfrei zu dem Ort, an dem die Texturierung vorgenommen wird, transportiert werden kann. Außerdem ist Fluorwasserstoff, aus dem das Fluorgas in dem Fluorgaserzeugungssystem herstellbar ist, unter entsprechendem Druck und/oder unter entsprechender Kühlung als Flüssigkeit wesentlich platzsparender lager- und transportierbar als Fluorgas.

Bei der Elektrolyse entsteht Fluorgas üblicherweise bei Atmosphärendruck. Zur Verwirklichung eines höheren Druckes ist es daher von Vorteil, wenn zwischen dem Fluorgaserzeugungssystem und dem Plasmaätzraum wenigstens eine Druckerhöhungseinrichtung vorgesehen ist. Nach der Druckerhöhungseinrichtung kann ein gesonderter Druckbehälter vorgesehen sein, in dem das erzeugte Fluorgas unter Druck zwischengespeichert werden kann. Der zu erreichende Druck für das Fluorgas in einem solchen Druckbehälter liegt vorzugsweise in einem Bereich von 1 bar bis 3,5 bar Überdruck. Der Druck im Plasmaätzraum ist niedriger als Atmosphärendruck, bevorzugt niedriger als 100 mbar, besonders bevorzugt niedriger als 10 mbar. Um den Druck des Fluorgases entsprechend von dem Druckbehälter oder direkt von der Fluorquelle zu dem Plasmaätzraum zu verringern, kann in einer entsprechenden Gasleitung zwischen der Fluorquelle und dem Plasmaätzraum wenigstens ein Druckminderventil und/oder ein Massendurchflussregler vorgesehen sein. Wenigstens ein entsprechendes Druckminderventil und/oder ein Massendurchflussregler kann/können auch in der Gasleitung zwischen der Schwefeloxidquelle und dem Plasmaätzraum vorgesehen sein. Sollten weitere Gase aus anderen Gasquellen in den Plasmaätzraum geleitet werden, kann/können dort ebenfalls in der Gasleitung zwischen der Gasquelle und dem Plasmaätzraum wenigstens ein Druckminderventil und/oder ein Massendurchflussregler vorgesehen sein.

Vorteilhaft ist weiterhin, wenn das Fluorgas näher an der Substratoberfläche in den Plasmaätzraum eingeleitet wird als die sonstigen in dem Verfahren verwendeten Prozessgase, wie z. B. das Schwefeloxid. Somit wird gewährleistet, dass das besonders reaktive Fluorgas einen möglichst kurzen Weg zu der zu texturierenden Substratoberfläche passieren muss. Anderenfalls kann es zu Nebenreaktionen des Fluorgases mit anderen für das Plasma genutzten Gasen kommen, beispielsweise mit dem Schwefeloxid, was die Atomeffizienz des eingesetzten Fluorgases negativ beeinflussen kann. Das Schwefeloxid und eventuell weitere verwendete Hilfsgase werden weiter von der Substratoberfläche entfernt als das Fluorgas in den Plasmaätzraum eingeleitet, wo sie sich mit dem Fluorgas bzw. der Fluorspezies im Plasma vermischen können.

In einer weiteren vorteilhaften Ausbildung des erfindungsgemäßen Verfahrens werden beim Ätzen nicht verbrauchte Prozessgase und beim Ätzen entstehende Abgase über wenigstens einen Gasauslass aus dem Plasma abgeleitet und nachfolgend durch wenigstens eine nasschemische Abgasbehandlungsvorrichtung geleitet. In der nasschemischen Abgasbehandlungsvorrichtung können bei dem erfindungsgemäßen Verfahren nicht verbrauchte Ätzgase, also beispielsweise Fluor und wenigstens Schwefeloxid, aber auch bei der Reaktion entstehende Gase, beispielsweise Siliziumtetrafluorid, Fluorwasserstoff und/oder Sauerstoffdifluorid, ad- und/oder absorbiert werden. Beispielsweise kann eine Abgasbehandlungsvorrichtung als Wäscher ausgebildet sein, um besagte Gase in Lösung zu absorbieren und/oder chemisch umzuwandeln. Hierdurch können giftige und/oder sauer reagierende Stoffe aus dem Abgas herausgewaschen werden. Die in der Abgasbehandlungsvorrichtung eventuell anfallenden sauren Rückstände, etwa Fluorwasserstoffsäure, auch Flusssäure genannt, können anschließend durch eine Neutralisation mit wenigstens einer Base in unbedenklichen Abfall überführt werden.

Vorzugsweise wird das Plasma bei dem erfindungsgemäßen Verfahren bei einer Frequenz im Mikrowellenbereich oder durch wenigstens eine induktiv gekoppelte Plasmaquelle, auch "inductively coupled plasma"-Quelle oder ICP-Quelle genannt, erzeugt. Die Verwendung von Mikrowellenplasmaquellen oder ICP-Quellen bietet den Vorteil, dass hier im Wesentlichen keine Beschleunigung von Ionen und/oder Radikalen mithilfe einer Potentialdifferenz in Richtung der Substratoberfläche, also im Wesentlichen kein physikalisches Ätzen der Substratoberfläche und eine dadurch bedingte Kristallschädigung des Siliziumsubstrates an der Substratoberfläche, erfolgt. Hierdurch kann beispielsweise eine Kristallverspannung des texturierten Substrates weitgehend verhindert werden. In einer alternativen Ausführungsvariante ist auch die Erzeugung eines Plasmas im Hochfrequenzbereich möglich.

In einer weiteren bevorzugten Ausführungsform des erfindungsgemäßen Verfahrens werden die Siliziumsubstrate im Plasmaätzraum durch eine Substrattemperiervorrichtung geheizt und/oder gekühlt. So kann beispielsweise eine Reaktionstemperatur für den Texturierprozess von weniger als 200 °C, bevorzugt von weniger als 150 °C, besonders bevorzugt von weniger als 100 °C an der Substratoberfläche im Plasma erreicht werden. Hierdurch kann die Selektivität des Texturierungsverfahrens im Vergleich zu einem hauptsächlich ätzenden Materialabtrag erhöht werden.

In einer besonders vorteilhaften Weiterbildung des erfindungsgemäßen Verfahrens werden Siliziumsubstrate kontinuierlich auf einer Substrattransportvorrichtung durch den Plasmaätzraum hindurchgefahren. Somit wird eine Anlage, in der das Verfahren durchführbar ist, kontinuierlich mit Siliziumwafern bestückt, was eine zeitlich und energetisch effizientere Betriebsweise ermöglicht als ein sogenanntes "Batch-Verfahren".

Die Aufgabe wird ferner durch eine Vorrichtung der oben genannten Gattung gelöst, bei der die Gaszuführeinrichtung außerdem mit wenigstens einer Schwefeloxidquelle gekoppelt ist. Schwefeloxid umfasst hier und im Folgenden Verbindungen der allgemeinen Summenformel SₓO_{y}, wie beispielsweise Dischwefelmonoxid, Schwefelmonoxid, Schwefeldioxid, Dischwefeldioxid und/oder Schwefeltrioxid.

Mit der Fluorgasquelle kann dem Plasma Fluorgas zugeführt werden, mit dem Silizium mit sehr genau einstellbarer Ätzrate geätzt werden kann. Im Gegensatz zu im Stand der Technik bekannten Vorrichtungen ist die Gaszuführeinrichtung der erfindungsgemäßen Vorrichtung nicht nur mit einer Fluorquelle, sondern darüber hinaus auch mit einer Schwefeloxidquelle gekoppelt.

Bei der erfindungsgemäßen Vorrichtung kann also dem Plasmaätzraum gasförmiges Schwefeloxid und Fluorgas für einen Plasmaätzprozess zum Texturieren von Siliziumoberflächen zugeführt werden. In der erfindungsgemäßen Vorrichtung kann damit ein plasmaangeregter chemischer Ätzprozess zum Texturieren von Siliziumoberflächen verwirklicht werden. In dem in dem Plasmaätzraum erzeugbaren Plasma werden aus den zugeführten Gasen Radikale, reaktive Ionen sowie Atome und Moleküle in angeregten Zuständen erzeugt, die mit der Siliziumoberfläche und darauf eventuell vorhandenem oder gebildetem Siliziumoxid reagieren können. Dies ermöglicht die Bearbeitung von unterschiedlichsten Siliziumsubstraten, da in der erfindungsgemäßen Vorrichtung im Gegensatz zu physikalischen oder rein chemischen Ätzvorrichtungen Siliziumsubstrate unabhängig von beispielsweise kristallografischen Eigenschaften der zu behandelnden Substratoberfläche oder vom eingesetzten Substratherstellungsverfahren texturiert werden können. In der erfindungsgemäßen Vorrichtung sind also beispielsweise sowohl von Diamantdraht gesägte Wafer als auch sehr dünne Substrate vorteilhaft einseitig oder beidseitig texturierbar. Die erfindungsgemäße Vorrichtung ermöglicht im Gegensatz zu aus dem Stand der Technik bekannten RIE(reactive ion etching)-Ätzvorrichtungen eine sanfte Oberflächenätzung und -strukturierung der Siliziumoberfläche, wodurch beispielsweise Kristallverspannungen oder dergleichen vermieden werden können.

Im Gegensatz zu Vorrichtungen, die zum nasschemischen Texturieren ausgebildet sind, kann mit der erfindungsgemäßen Vorrichtung auch ein Einseitenprozess realisiert werden, bei welchem ein Siliziumsubstrat nur an einer gewünschten Oberfläche texturiert wird. Somit werden durch die Verwendung der erfindungsgemäßen Vorrichtung weniger Chemikalien benötigt als bei der Verwendung von Vorrichtungen, welche bei einem nasschemischen Texturierprozess eingesetzt werden. Bei Einsatz der erfindungsgemäßen Vorrichtung entfällt somit die bei nasschemischen Ätzvorrichtungen bekannte Aufarbeitung von kontaminiertem deionisierten Wasser. Ferner ist eine nachträgliche Politur der Rückseite der Siliziumsubstrate bei Verwendung der erfindungsgemäßen Vorrichtung nicht nötig. Die bei der erfindungsgemäßen Vorrichtung entstehenden chemischen Abprodukte sind gasförmig und können über wenigstens einen Gasauslass der Vorrichtung von der Substratoberfläche gut abgeleitet werden. Gleichzeitig können dem Plasmaätzraum stetig neue Ätz-, Prozess- und/oder Hilfsgase zugeführt werden. Somit ist einerseits die Reaktionsgeschwindigkeit in der erfindungsgemäßen Vorrichtung unabhängig von der Prozessdauer und andererseits entstehen viel weniger aufzubereitende Abfälle als bei nasschemischen Texturiervorrichtungen.

Bei der erfindungsgemäßen Vorrichtung sind dem Ätzraum Gase zuführbar, welche einen sehr geringen oder keinen Treibhauseffekt aufweisen und sich auf einfache Weise aus den Prozessabgasen entfernen lassen. Die bei der erfindungsgemäßen Vorrichtung auszuscheidenden Abgase, wie beispielsweise Siliziumtetrafluorid, Fluorgas, Sauerstoffdifluorid und/oder Fluorwasserstoff, sind umweltneutral oder zu umweltneutralen Verbindungen in der Abgasbehandlung umsetzbar oder aber zumindest neutral in Hinsicht auf die Klimaerwärmung. Darüber hinaus eröffnet die erfindungsgemäße Vorrichtung die Möglichkeit, nur sehr wenige bis gar keine umweltschädlichen Abgase in die Umwelt zu entlassen. Außerdem wird der Einsatz von Chemikalien gegenüber Vorrichtungen, in welchen nasschemische Texturierprozesse durchführbar sind sowie gegenüber Vorrichtungen, in welchen andere Prozessgase genutzt werden, wesentlich verringert, da beispielsweise die chemische Umsetzungseffizienz des eingesetzten Fluorgases in dieser Vorrichtung mindestens 80 % bis 90 % betragen kann.

Nach einer vorteilhaften Weiterbildung der erfindungsgemäßen Vorrichtung ist die Fluorquelle ein mit dem Plasmaätzraum gekoppeltes Fluorgasversorgungs- und/oder Fluorgaserzeugungssystem, in dem Fluor vor dessen Zuleitung in den Plasmaätzraum durch Elektrolyse aus Fluorwasserstoff erzeugbar ist. Somit ist es möglich, Fluorgas direkt an der Texturierungsvorrichtung zu generieren, wodurch ein Transport und/oder eine Lagerung von Fluorgas nicht notwendig ist/sind. Stattdessen ist Fluorwasserstoff, aus dem das Fluorgas in dem Fluorgaserzeugungssystem herstellbar ist, unter entsprechendem Druck und/oder unter entsprechender Kühlung als Flüssigkeit wesentlich platzsparender lagerbar als Fluorgas. Außerdem kann durch diese Ausführungsform der Erfindung die Bereitstellung von Fluorgas entsprechend von der Gasanforderung des Texturierungsprozesses abhängig gemacht werden.

In einer vorteilhaften Variante der erfindungsgemäßen Vorrichtung ist/sind zwischen dem Fluorgaserzeugungssystem und dem Plasmaätzraum wenigstens ein Reinigungsmodul und/oder eine Druckerhöhungseinrichtung vorgesehen. Das Fluorgas, welches bei der Elektrolyse in dem Fluorgaserzeugungssystem gebildet wird, kann in der Regel noch Fluorwasserstoff enthalten. Daher ist die Durchleitung des in dem Fluorgaserzeugungssystem erzeugten Gasgemisches durch ein Reinigungsmodul vorteilhaft, in dem Fluorwasserstoff und eventuelle andere Verunreinigungen entfernt werden können, sodass Fluorgas hoher Reinheit in den Plasmaätzraum eingeleitet werden kann. Weiterhin strömt das Gasgemisch typischerweise mit Atmosphärendruck aus dem Fluorgaserzeugungssystem zu dem Plasmaätzraum. Um einen höheren als Atmosphärendruck zu erzielen, ist die Verwendung einer Druckerhöhungseinrichtung zwischen dem Fluorgaserzeugungssystem und dem Plasmaätzraum von Vorteil. Eine derartige Druckerhöhungseinrichtung kann in einer möglichen Ausführungsvariante beispielsweise aus einem Verdichter und einem Druckbehälter, welcher als Vorrat für verdichtetes Fluorgas dient, bestehen.

In einer alternativen Ausführungsform der vorliegenden Erfindung kann die Fluorquelle auch in Form wenigstens einer Druckgasflasche ausgebildet sein. In diesem Fall kann auf ein Reinigungsmodul und/oder eine Druckerhöhungsstufe verzichtet werden. Die Druckgasflasche dient in diesem Fall sowohl als Fluorquelle als auch als Druckbehälter.

In jeder dieser Ausführungsvarianten ist es von Vorteil, wenn in der Gasleitung zwischen der Fluorquelle und dem Plasmaätzraum wenigstens ein Druckminderventil und/oder ein Massendurchflussregler vorgesehen ist/sind. Dies ermöglicht, den Druck des Fluorgases an den des Plasmaätzraumes anzugleichen, wo bevorzugt ein Druck von weniger als 100 mbar, besonders bevorzugt von weniger als 10 mbar vorherrscht, beziehungsweise einen definierten Gasfluss einzustellen. Wenigstens ein entsprechendes Druckminderventil und/oder ein Massendurchflussregler ist/sind vorzugsweise auch in der Gasleitung zwischen der Schwefeloxidquelle und dem Plasmaätzraum vorgesehen. Sollten weitere Gase aus anderen Gasquellen in den Plasmaätzraum geleitet werden, ist/sind dort vorzugsweise entsprechend auch stets in der Gasleitung zwischen der Gasquelle und dem Plasmaätzraum wenigstens ein Druckminderventil und/oder ein Massendurchflussregler vorgesehen.

Besonders bevorzugt ist eine Ausführungsform der vorliegenden Erfindung, in der ein mit der Fluorquelle verbundener Gaseinlass der Gaszuführeinrichtung näher an der Substratoberfläche als ein mit der Schwefeloxidquelle verbundener Gaseinlass der Gaszuführeinrichtung vorgesehen ist. Die Gaseinlässe sind im Plasmaätzraum vorzugsweise oberhalb der Substrattransportvorrichtung angeordnet. Die wenigstens zwei Gaseinlässe, die wenigstens der Zuführung von Fluorgas und Schwefeloxid dienen, sind in einer bevorzugten Ausführungsform der Erfindung vertikal in verschiedenen Höhen angeordnet, das heißt, es gibt wenigstens einen oberen und einen unteren Gaseinlass, wobei der obere, mit der Schwefeloxidquelle verbundene Gaseinlass relativ zur Substratoberfläche ferner als der untere, mit der Fluorquelle verbundene Gaseinlass angeordnet ist. Somit ist Fluorgas in besonderer Nähe zur Substratoberfläche in den Plasmaätzraum einleitbar, während Schwefeloxid und je nach Ausführungsform weitere Prozess- und/oder Hilfsgase in größerer Entfernung zur Substratoberfläche als Fluorgas in den Plasmaätzraum einleitbar sind.

In einer vorteilhaften Weiterbildung der erfindungsgemäßen Vorrichtung weist der Plasmaätzraum wenigstens einen Gasauslass auf, der in wenigstens eine nasschemische Abgasbehandlungsvorrichtung mündet. Die Abgasbehandlungsvorrichtung dient zur Ad- und/oder Absorption giftiger und/oder sauer reagierender, in der erfindungsgemäßen Vorrichtung nicht verbrauchter und/oder entstehender Gase mithilfe nasschemischer Prozesse. Zu diesen Gasen zählen vor allem Fluorgas, Siliziumtetrafluorid, Sauerstoffdifluorid, Schwefeldioxid oder auch Fluorwasserstoff. Die Abgasbehandlungsvorrichtung kann in einer vorteilhaften Ausführungsform der Erfindung einen Wäscher und gegebenenfalls einen Brenner aufweisen, in dem die Gase in Lösung absorbiert und/oder chemisch umgewandelt werden. In einem solchen Wäscher kann aus den fluoridhaltigen Stoffen im Abgas beispielsweise Fluorwasserstoffsäure, auch Flusssäure genannt, gebildet werden, welche anschließend in der Abgasbehandlungsvorrichtung mithilfe von wenigstens einer Base neutralisiert werden kann, sodass unbedenkliche Abfälle resultieren.

In einer weiteren Ausführungsform der erfindungsgemäßen Vorrichtung ist die wenigstens eine Plasmaquelle als eine Mikrowellenplasmaquelle und/oder als eine induktiv gekoppelte Plasmaquelle, auch "inductively coupled plasma"-Quelle oder ICP-Quelle genannt, ausgebildet. Das Plasma ermöglicht die Bearbeitbarkeit von unterschiedlichsten Siliziumsubstraten, der Prozess ist unabhängig von beispielsweise kristallografischen Eigenschaften der zu behandelnden Substratoberfläche oder vom eingesetzten Substratherstellungsverfahren. Außerdem liegt somit ein echter Einseitenprozess vor, wodurch eine nachträgliche Politur der Substratrückseite entfällt. Die Plasmaquelle ist vorzugsweise eine lineare Plasmaquelle, also eine sich über die Vorrichtungsbreite erstreckende Plasmaquelle. Dadurch ist es möglich, breite Substratträger mit einer Vielzahl an Substraten gleichzeitig in der erfindungsgemäßen Vorrichtung einzusetzen und somit eine Vielzahl an Substraten gleichzeitig zu texturieren. In einer alternativen Ausführungsform der Erfindung kann die Plasmaquelle auch als Hochfrequenzplasmaquelle ausgebildet sein.

In einer vorteilhaften Variante der erfindungsgemäßen Vorrichtung ist in dem Plasmaätzraum eine Substrattemperiervorrichtung vorgesehen. Diese kann beispielsweise als Umlauf-Heiz-Kühler ausgebildet sein und zur Kühlung und/oder Heizung des Substrates eingesetzt werden, um so beispielsweise eine Reaktionstemperatur für den Texturierprozess von weniger als 200 °C, bevorzugt von weniger als 150 °C, besonders bevorzugt von weniger als 100 °C an der Substratoberfläche im Plasma zu realisieren. Alternativ kann das Substrat mit der Substrattemperiervorrichtung auch bei Bedarf geheizt werden. So ist es beispielsweise möglich, mit Hilfe der Substrattemperiervorrichtung das oder die Substrat(e) derart zu erhitzen, dass Verunreinigungen auf dem Substrat bzw. den Substraten durch Sublimation entfernt werden können. Die Substrattemperiervorrichtung kann bei der vorliegenden Erfindung auch als reine Substratkühlvorrichtung ausgebildet sein. Durch eine Substratkühlvorrichtung kann eine gute Texturierung der Substratoberfläche bei gleichzeitig verringertem Materialabtrag von dem Siliziumsubstrat erreicht werden.

In einer weiteren Ausgestaltung ist die erfindungsgemäße Vorrichtung eine Durchlaufanlage mit einer den Plasmaätzraum durchfahrenden Substrattransportvorrichtung für das wenigstens eine zu texturierende Siliziumsubstrat. Somit ist mit der erfindungsgemäßen Vorrichtung ein kontinuierliches Bestücken der Anlage mit Siliziumwafern möglich, was eine zeitlich und energetisch effizientere Betriebsweise als ein sogenanntes "Batch-Verfahren" ermöglicht.

Vorteilhafte Ausführungsformen der vorliegenden Erfindung, deren Aufbau, Funktion und Vorteile sind im Folgenden anhand von Figuren näher erläutert, wobei
- Figur 1: schematisch eine Ausführungsform der erfindungsgemäßen Vorrichtung mit einer Fluorgasquelle, einer Schwefeloxidquelle, einer Edelgasquelle, einer Sauerstoffquelle und einer Mikrowellenplasmaquelle in einer Querschnittsdarstellung zeigt;
- Figur 2: schematisch eine alternative Ausführungsform der erfindungsgemäßen Vorrichtung mit einer Fluorgasquelle in Form eines Fluorgaserzeugungssystems, einer Schwefeloxidquelle, einer Edelgasquelle, einer Sauerstoffquelle und einer Mikrowellenplasmaquelle in einer Querschnittsdarstellung zeigt;
- Figur 3: schematisch eine alternative Ausführungsform der erfindungsgemäßen Vorrichtung mit einer Fluorgasquelle, einer Schwefeloxidquelle, einer Edelgasquelle, einer Sauerstoffquelle und einer ICP-Quelle in einer Querschnittsdarstellung zeigt; und
- Figur 4: schematisch eine mögliche Prozessabfolge des erfindungsgemäßen Verfahrens zeigt.

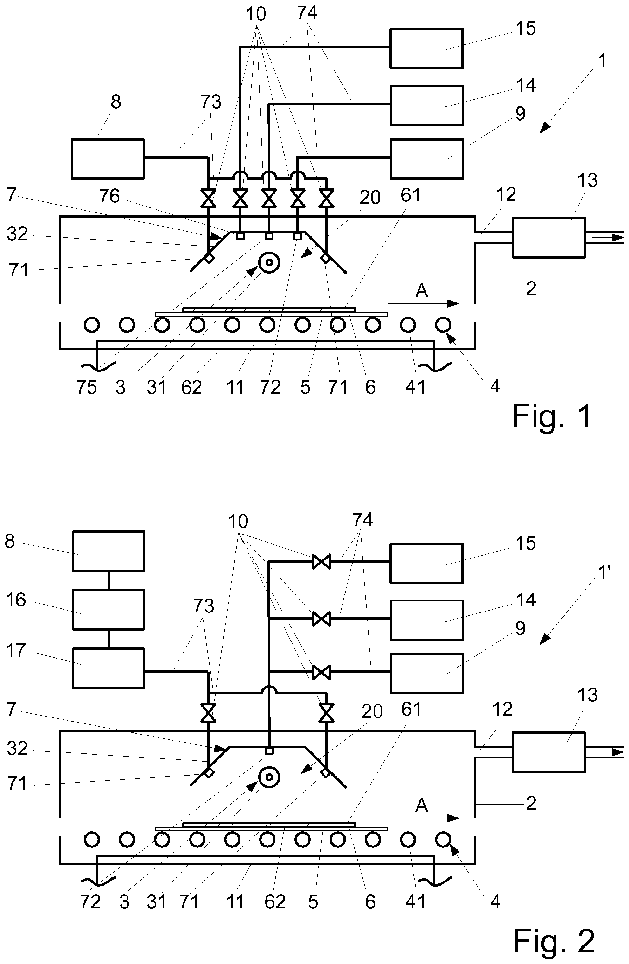

Figur 1 zeigt schematisch in einem Querschnitt eine erfindungsgemäße Vorrichtung 1 zum Texturieren der Substratoberfläche 61 wenigstens eines Siliziumsubstrates 6. Die Vorrichtung 1 ist vorzugsweise und wie in den gezeigten Ausführungsbeispielen dargestellt eine Durchlauf- oder Inline-Anlage, durch welche das bzw. die zu prozessierende(n) Siliziumsubstrat(e) 6 während eines in der Vorrichtung 1 vorgenommenen Texturierungsprozesses hindurchgefahren wird/werden.

Die in Figur 1 beispielhaft gezeigte Vorrichtung 1 weist einen Plasmaätzraum 2 auf, in dem eine Plasmaquelle 3 in einer oberen Hälfte des Plasmaätzraums 2 vorgesehen ist. In alternativen, nicht gezeigten Ausführungsformen kann die Plasmaquelle 3 auch in einer unteren Hälfte des Plasmaätzraums 2 oder es können mehrere Plasmaquellen 3 vorgesehen sein, die sowohl in einer unteren und einer oberen Hälfte des Plasmaätzraums 2 angeordnet sind.

Die Plasmaquelle 3 ist in den Figuren 1 und 2 eine Mikrowellenplasmaquelle. Die Mikrowellenplasmaquelle ist in den gezeigten Ausführungsbeispielen als Rohr 31 mit innenliegender Antenne ausgebildet, in dem elektromagnetische Strahlung im Mikrowellenbereich erzeugt wird. Das Rohr 31 ist länglich ausgebildet und verläuft in die Bildebene von Figur 1 hinein. In dem Rohr 31 wird vorzugsweise eine stehende Welle generiert. Benachbart zu dem Rohr 31 ist eine Gaseinlasshaube 32 angeordnet, welche das Rohr 31 zu drei Seiten hin gegenüber dem Plasmaätzraum 2 abgrenzt, wohingegen eine zur Substratoberfläche 61 gerichtete Seite offen verbleibt. Zwischen dem Rohr 31 und der Gaseinlasshaube 32 bestehen in einer besonders bevorzugten Ausführungsform keine Berührungspunkte. Mit Hilfe der Plasmaquelle 3 wird in dem Plasmaätzraum 2 ein Plasma 20 erzeugt.

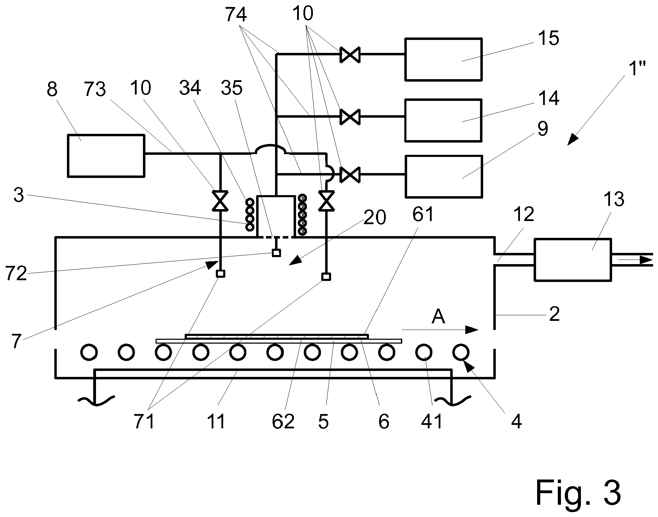

In einer alternativen Ausführungsform der erfindungsgemäßen Vorrichtung kann die Plasmaquelle 3 eine ICP-Quelle sein, wie in Figur 3 gezeigt. In anderen, nicht gezeigten Ausführungsformen der vorliegenden Erfindung kann anstelle der Mikrowellenplasmaquelle auch eine im Hochfrequenzbereich arbeitende Plasmaquelle 3 verwendet werden.

In der erfindungsgemäßen Vorrichtung 1 können mehrere Plasmaquellen in den gezeigten Figuren sowohl in der in die Bildebene hinein verlaufenden Richtung nebeneinander als auch unterhalb der Substrattransportvorrichtung 4 senkrecht zur Substrattransportrichtung A angeordnet sein. Dabei kann/können beispielsweise eine oder mehrere Plasmaquelle(n) 3 eine ICP-Quelle sein, während wenigstens eine weitere Plasmaquelle 3 eine Mikrowellenplasmaquellen ist.

In der in Figur 1 gezeigten Ausführungsform ist in einer unteren Hälfte des Plasmaätzraums 2 der Vorrichtung 1 eine Substrattransportvorrichtung 4 vorgesehen. Die Substrattransportvorrichtung 4 weist in dem gezeigten Ausführungsbeispiel Transportrollen 41 auf, auf welchen ein Substratträger 5 in einer Substrattransportrichtung A und/oder entgegen dieser Substrattransportrichtung A durch den Plasmaätzraum 2 transportierbar ist. Die Transportrollen 41 verlaufen in die Bildebene von Figur 1 hinein. In anderen, nicht gezeigten Ausführungsformen der vorliegenden Erfindung kann die Substrattransportvorrichtung 4 auch andere Transportmechanismen als die gezeigten Transportrollen 41, wie beispielsweise wenigstens ein Transportband, aufweisen oder der Substratträger 5 kann entlang von Laufschienen beweglich sein.

Auf dem Substratträger 5 ist während eines in der Vorrichtung 1 ausgeführten Texturierungsprozesses wenigstens ein Siliziumsubstrat 6 vorgesehen, dessen Substratoberfläche 61 in dem Prozess zu texturieren ist. Hierbei wird das Siliziumsubstrat 6 in den in den Figuren 1 bis 3 gezeigten Ausführungsbeispielen mit der zu texturierenden Oberfläche 61 nach oben auf dem Substratträger 5 durch den Plasmaätzraum 2 hindurch transportiert. Damit kann die frontseitige Substratoberfläche 61, welche dem Plasma 20 ausgesetzt ist, texturiert werden, während eine Substratrückseite 62 des Substrates 6, welche auf dem Träger 5 aufliegt, nicht dem Plasma 20 ausgesetzt ist.

Die Zuführung der jeweiligen Gaskomponenten zu dem Plasmaätzraum 2 erfolgt durch eine Gaszuführeinrichtung 7. Die Gaszuführeinrichtung 7 weist mit einer Fluorquelle 8 verbundene Gaseinlässe 71 sowie einen mit einer Schwefeloxidquelle 9 verbundenen Gaseinlass 72 auf. Die Gaseinlässe 71 sind über ein Gasleitungssystem 73 mit der Fluorquelle 8 verbunden. Der Gaseinlas 72 ist über eine Gasleitung 74 mit der Schwefeloxidquelle 9 verbunden. Wie in Figur 1 dargestellt, münden in den Plasmaätzraum 2 weitere Gaseinlässe 75 und 76, die über Gasleitungen 74 mit einer Argonquelle 14 und einer Sauerstoffquelle 15 verbunden sind. In den Gasleitungen 73 und 74 ist jeweils ein Massendurchflussregler 10 vorgesehen. Anstelle von den Massendurchflussreglern 10 können auch Druckminderventile eingesetzt werden. In einer alternativen Ausführungsform, wie beispielsweise in Figur 2 gezeigt, können Prozess- und Hilfsgase, wie z. B. das Schwefeloxid, der Sauerstoff und/oder das Argon, auch vorgemischt und gemeinsam in den Plasmaätzraum 2 eingeleitet werden. Die Fluorgaszuführung zu dem Plasmaätzraum 2 erfolgt vorzugsweise separat von den weiteren Prozess- und Hilfsgasen.

Die Gaseinlässe 71, 72, 75, 76 erstrecken sich in dem gezeigten Ausführungsbeispiel über die Breite der Vorrichtung 1, das heißt in den Figuren 1 bis 3 in die Bildebene hinein. Die Gaseinlässe 71, 72, 75, 76 können in Form von Rohren oder beispielsweise Vierkantprofilen ausgebildet sein. Über diese Längserstreckung weisen die Gaseinlässe 71, 72, 75, 76 Öffnungen auf, aus denen das jeweilige Gas oder Gasgemisch in den Plasmaätzraum 2 und insbesondere zur Substratoberfläche 61 strömen kann.

In den dargestellten Ausführungsbeispielen sind die Gaseinlässe 71, 72, 75, 76 an einer oberhalb des zu texturierenden Siliziumsubstrates 6 vorgesehenen, trichterförmig ausgebildeten Gaseinlasshaube 32 vorgesehen. Dabei sind die Gaseinlässe 71 an einer seitlichen Innenwand der Gaseinlasshaube 32 und die Gaseinlässe 72, 75, 76 an einer oberen Innenwand der Gaseinlasshaube 32 angeordnet.

In dem Plasmaätzraum 2 ist eine Substrattemperiervorrichtung 11 vorgesehen. In dem Plasma 20 werden häufig Temperaturen von weit größer als 180 °C erzeugt, welche jedoch für den Texturierprozess ungünstig hoch sind. Daher ist die Substrattemperiervorrichtung 11 derart ausgebildet, dass das Siliziumsubstrat 6 und/oder die Substratoberfläche 61 in dem Plasma 20 auf Temperaturen von weniger als 200 °C, bevorzugt von weniger als 150 °C, besonders bevorzugt von weniger als 100 °C gekühlt werden kann/können. Beispielsweise kann die Substrattemperiervorrichtung 11, wie in den Figuren 1 bis 3 schematisch dargestellt, in Form einer unterhalb der Substrattransportvorrichtung 4 vorgesehenen Fluidkühlvorrichtung ausgebildet sein. Alternativ sind andere Ausführungsformen einsetzbar, beispielsweise können die Transportrollen 41 direkt von einem fluiden Temperiermedium durchflossen werden. Grundsätzlich kann die Substrattemperiervorrichtung 11 jedoch auch zum Heizen des Innenraums des Plasmaätzraumes 2 und/oder des oder der Substrat(e) verwendet werden.

An dem Plasmaätzraum 2 ist ein Gasauslass 12 vorgesehen, der in eine nasschemische Abgasbehandlungsvorrichtung 13 mündet. Somit können beim Texturierungsprozess nicht verbrauchte Prozess- und Hilfsgase sowie beim Texturierungsprozess entstehende Gase aus dem Plasmaätzraum 2 durch den Gasauslass 12 abgeführt werden. In anderen Ausführungsformen der vorliegenden Erfindung können auch mehrere Gasauslässe 12 vorgesehen sein.

In der Abgasbehandlungsvorrichtung 13 werden giftige, umweltschädliche und/oder sauer reagierende Gase nasschemisch ad- und/oder absorbiert. Zu diesen, aus den Abgasen zu entfernenden Gasen zählen beispielsweise Fluor, Schwefeldioxid, Siliziumtetrafluorid, Fluorwasserstoff, Sauerstoffdifluorid und/oder weitere Gase. Manche oder alle dieser Gase können in der Abgasbehandlungsvorrichtung 13 chemische Reaktionen eingehen, sodass sie zu anderen, weniger gefährlichen Substanzen umgesetzt werden. Dabei entstehende oder bereits vorhandene sauer reagierende Stoffe, wie beispielsweise Fluorwasserstoffsäure, auch Flusssäure genannt, können durch die Zugabe von wenigstens einer Base neutralisiert werden, um so unbedenkliche Abfälle zu erhalten.

In Figur 1 ist eine mögliche Ausführungsform dargestellt, in der jede Gasquelle 8, 9, 14, 15 jeweils mit einer oder mehreren separaten Gaseinlässen 71, 72, 75, 76 verbunden ist. Alternativ dazu ist in Figur 2 eine Ausführungsform der erfindungsgemäßen Vorrichtung 1' dargestellt, in der die Gasleitungen 74, welche von der Schwefeloxidquelle 9, der Argonquelle 14 und der Sauerstoffquelle 15 ausgehen, verbunden sind, bevor eine Gaseinleitung in den Plasmaätzraum 2 durch den Gaseinlass 72 erfolgt. In der Vorrichtung 1' in Figur 2 werden somit Schwefeloxid, Argon und Sauerstoff über einen gemeinsamen Gaseinlass 72 in den Plasmaätzraum 2 eingeleitet. In anderen, nicht gezeigten Ausführungsformen der vorliegenden Erfindung können zwei oder mehr der verwendeten Prozessgase vor ihrer Zuführung zu dem Gaseinlass 72 vermischt werden.

In der in Figur 2 dargestellten Vorrichtung 1' ist die Fluorquelle 8 als Fluorgaserzeugungssystem ausgebildet. Das Fluorgaserzeugungssystem ist in der gezeigten Ausführungsform mit einem Reinigungsmodul 16 und einer Druckerhöhungseinrichtung 17 verbunden. In dem Fluorgaserzeugungssystem wird eine Elektrolyse von Fluorwasserstoff durchgeführt, bei der Fluorgas und Wasserstoffgas gebildet werden. Zur Gewinnung von Fluorgas hoher Reinheit ist nach dem Fluorgaserzeugungssystem das Reinigungsmodul 16 vorgesehen. In dem Reinigungsmodul 16 kann eine Trennung des Fluorgases von den weiteren Abgasen vorgenommen werden. Nach dem Reinigungsmodul 16 ist eine Druckerhöhungseinrichtung 17 vorgesehen, welche beispielsweise einen Verdichter und/oder einen Druckbehälter umfassen kann.

In Figur 3 ist ein weiteres Ausführungsbeispiel einer erfindungsgemäßen Vorrichtung 1" dargestellt, bei der eine ICP-Quelle als Plasmaquelle 3 das Plasma 20 in dem Plasmaätzraum 2 erzeugt. Die von der Schwefeloxidquelle 9, der Argonquelle 14 und der Sauerstoffquelle 15 ausgehenden Gasleitungen 74 führen auch hier in einen Gaseinlass 72 in dem Plasmaätzraum 2. Oberhalb des Plasmaätzraumes 2 ist die Plasmaquelle 3 angeordnet. Die Plasmaquelle 3 weist eine Spule 34 auf, deren Magnetfeld über ein dielektrisches Fenster 35, welches beispielsweise aus Keramik, Glas oder Quarz ausgebildet sein kann, in den Plasmaätzraum 2 eingekoppelt wird, um darin Atome und/oder Moleküle der darin befindlichen Gase zu ionisieren und damit das Plasma 20 auszubilden. Die Gaseinlässe 71 für das Fluorgas sind näher an der Substratoberfläche 61 angeordnet als der Gaseinlass 72 für die weiteren Prozess- und Hilfsgase. Somit vermischt sich das Fluorgas erst kurz oberhalb der Substratoberfläche 61 im Plasma mit den weiteren Prozess- und Hilfsgasen.

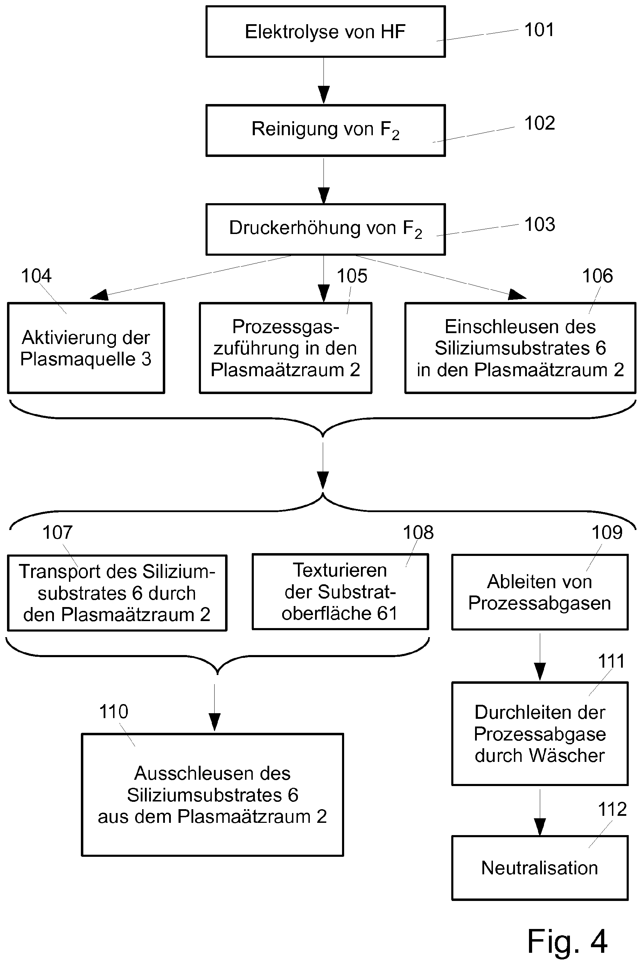

Ein Ausführungsbeispiel für ein an der der erfindungsgemäßen Vorrichtung 1, 1', 1" ausführbares Texturierungsverfahren ist schematisch in Figur 4 dargestellt. In dem erfindungsgemäßen Verfahren werden als Prozessgase Fluorgas und wenigstens Schwefeloxid für die Texturierung des kristallinen Siliziumsubstrates 6 genutzt. Weiterhin wird als weiteres Prozessgas ein Edelgas, beispielsweise Argon, eingesetzt. Das Edelgas wirkt dabei als stabilisierendes Medium für das Plasma 20. Ferner kann, wie in den oben beschriebenen Ausführungsformen erwähnt, beispielsweise Sauerstoff als weiteres Prozessgas dem Plasmaätzraum 2 zugeführt werden.

In dem Verfahrensbeispiel von Figur 4 wird in Schritt 101 das Fluorgas (F₂) in einem Fluorgaserzeugungssystem mittels Elektrolyse von Fluorwasserstoff (HF) hergestellt. Nachfolgend wird das Fluorgas in Schritt 102 gereinigt und in Schritt 103 unter Druck gesetzt. Vor, nach oder gleichzeitig mit der Aktivierung der Plasmaquelle 3 in Schritt 104 werden die Prozess- und Hilfsgase, wie Fluor, Schwefeloxid, Sauerstoff und Argon, in Schritt 105 dem Plasmaätzraum 2 zugeführt. Parallel oder im Nachgang dazu wird in Schritt 106 das wenigstens eine Siliziumsubstrat 6 in den Plasmaätzraum 2 eingeschleust.

Daraufhin wird das wenigstens eine Siliziumsubstrat 6 in Schritt 107 mithilfe der Substrattransportvorrichtung 4 in den gezeigten Beispielen kontinuierlich durch den Plasmaätzraum 2 in der Substrattransportrichtung A transportiert. Während des Transports des wenigstens einen Siliziumsubstrates 6 durch den Plasmaätzraum 2 erfolgt in Schritt 108 das Texturieren der Substratoberfläche 61.

Für ein effektives Texturieren sind das Mengenverhältnis der Prozessgase sowie die Prozesstemperatur entscheidend. In Volumenprozent ausgedrückt werden erfindungsgemäß 30 % bis 90 %, bevorzugt 40 % bis 80 %, besonders bevorzugt 50 % bis 70 % Fluorgas verwendet. Vom Schwefeloxid werden 5 % bis 55 %, bevorzugt 15 % bis 45 %, besonders bevorzugt 25 % bis 35 % eingesetzt. Als Schwefeloxid gelten alle Verbindungen der allgemeinen Summenformel SₓO_{y}, also beispielsweise Dischwefelmonoxid, Schwefelmonoxid, Schwefeldioxid, Dischwefeldioxid oder Schwefeltrioxid. Besonders bevorzugt wird Schwefeldioxid verwendet. Ein Plasma stabilisierendes Edelgas, besonders bevorzugt Argon, wird für den erfindungsgemäßen Prozess zu 1 % bis 25 %, bevorzugt 5 % bis 20 %, besonders bevorzugt 10 % bis 15 % hinzugegeben. Sauerstoff wird für den Prozess in Mengen weniger als 50 %, bevorzugt weniger als 20 %, besonders bevorzugt weniger als 10 % verwendet. Es hat sich hierbei gezeigt, dass durch die Verwendung von Sauerstoff die Polymerabscheidung auf dem wenigstens einen zu texturierenden Siliziumsubstrat 6 reduziert werden kann. Es hat sich dabei als besonders vorteilhaft erwiesen, Sauerstoff nicht über den gesamten Prozessverlauf kontinuierlich gleich bleibend beizumischen, sondern vorzugsweise zum Ende des Prozesses den Sauerstoffanteil leicht zu erhöhen.

Dieses Gemisch an Gasen, welches wie oben beschrieben durch die Gaszuführeinrichtung 7 bei einem resultierenden Druck von weniger als 100 mbar, besonders bevorzugt von weniger als 10 mbar in den Plasmaätzraum 2 eingeleitet wird, wird durch wenigstens eine geeignete Plasmaquelle 3 zu einem Plasma 20 gezündet. Die so entstehenden Teilchen, wie Radikale, Ionen sowie Atome und Moleküle in angeregten Zuständen, reagieren anschließend mit dem Siliziumsubstrat 6 und führen zu einer Texturierung der Substratoberfläche 61. In einem solchen Plasma 20 herrschen oftmals vergleichsweise hohe Temperaturen, abhängig vom gewählten Gasgemisch sowie der gewählten Plasmaquelle 3 und des vorherrschenden Druckes. Es hat sich herausgestellt, dass die Ergebnisse der Texturierung optimiert werden können, wenn für das Siliziumsubstrat 6 eine Substrattemperiervorrichtung 11 vorgesehen ist, welche insbesondere als Substratkühlvorrichtung ausgebildet ist. Somit können auf der Substratoberfläche 61 Reaktionstemperaturen von weniger als 200 °C, bevorzugt von weniger als 150 °C, besonders bevorzugt von weniger als 100 °C realisiert werden.

Mit dem erfindungsgemäßen Verfahren können an der Substratoberfläche 61 Texturen mit einer Texturgröße von weniger als 20 µm, insbesondere von weniger als 10 µm und besonders bevorzugt von weniger als 1 µm auf Siliziumsubstraten 6 erzeugt werden. Texturgröße bedeutet in diesem Zusammenhang die Größenordnung der Strukturen, welche durch das Texturieren auf der Substratoberfläche 61 hervorgerufen werden. Im Falle von Pyramiden oder inversen Pyramiden als Strukturelemente bedeutet die Texturgröße also beispielsweise eine Höhe oder eine Kantenlänge der Pyramiden. Im Falle von schwammartigen oder anderen wenig regelmäßigen Strukturelementen bedeutet die Texturgröße also beispielsweise eine Porengröße, ein Abstand von Profilpunkten gleicher Höhe in einem Höhenprofil der Substratoberfläche 61 oder ähnliches.

Es kann bei dem erfindungsgemäßen Verfahren eine Ätzrate von weniger als 5 µm/min, insbesondere von weniger als 1 µm/min, eingestellt werden, wodurch eine kontrollierte, materialschonende Texturierung möglich ist, also eine gezielte Abtragung von weniger als 5 µm, besonders bevorzugt von weniger als 2 µm Material. Durch mit dem erfindungsgemäßen Verfahren hervorgerufene Texturen können beispielsweise Solarzellen hergestellt werden, die einen hervorragenden gewichteten Reflektivitätswert in einem Wellenlängenbereich von 300 nm bis 1200 nm aufweisen, welcher kleiner als 20 %, insbesondere kleiner als 15 %, besonders bevorzugt etwa 12 % ist. Die gewichtete Reflekitvität ist bekanntermaßen normiert auf die Effektivität bestimmter Wellenlängen beziehungsweise Wellenlängenbereiche zur Ladungsträgererzeugung in Silizium.

Während der Texturierung erfolgt in Schritt 109 ein stetiges Ableiten der Prozessgase. In dem Verfahrensbeispiel von Figur 4 werden die Abgase in Schritt 111 durch einen Wäscher geleitet, in dem beispielsweise Fluorgas zu Fluorwasserstoffsäure umgewandelt wird. Die Fluorwasserstoffsäure sowie weitere eventuell entstehende Säuren werden nachfolgend in Schritt 112 unter Hinzufügung wenigstens einer Base neutralisiert.

Gemäß dem Schritt 110 erfolgt schließlich ein Ausschleusen des Siliziumsubstrates 6 aus dem Plasmaätzraum 2.

## Patentansprüche

1. Verfahren zum Texturieren wenigstens einer Substratoberfläche (61) wenigstens eines kristallinen Siliziumsubstrates (6) durch Ätzen der Substratoberfläche (61) mit Fluorgas, wobei das Ätzen des Siliziumsubstrates (6) in einem Plasma (20) vorgenommen wird, das in einem Plasmaätzraum (2) erzeugt wird,
**dadurch gekennzeichnet,**
**dass** dem Plasmaätzraum (2) neben Fluorgas wenigstens gasförmiges Schwefeloxid zugeführt wird.

2. Verfahren nach Anspruch 1, **dadurch gekennzeichnet, dass** das Fluorgas in wenigstens einem mit dem Plasmaätzraum (2) gekoppelten Fluorgaserzeugungssystem mittels Elektrolyse erzeugt und dem Plasmaätzraum (2) zugeführt wird.

3. Verfahren nach Anspruch 1 oder 2, **dadurch gekennzeichnet, dass** das Fluorgas näher an der Substratoberfläche (61) in den Plasmaätzraum (2) eingeleitet wird als die sonstigen in dem Verfahren verwendeten Prozessgase.

4. Verfahren nach wenigstens einem der vorhergehenden Ansprüche, **dadurch gekennzeichnet, dass** beim Ätzen nicht verbrauchte Prozessgase und beim Ätzen entstehende Abgase über wenigstens einen Gasauslass (12) aus dem Plasma (20) abgeleitet und nachfolgend durch wenigstens eine nasschemische Abgasbehandlungsvorrichtung (13) geleitet werden.

5. Verfahren nach wenigstens einem der vorhergehenden Ansprüche, **dadurch gekennzeichnet, dass** das Plasma (20) bei einer Frequenz im Mikrowellenbereich und/oder durch wenigstens eine induktiv gekoppelte Plasmaquelle erzeugt wird.

6. Verfahren nach wenigstens einem der vorhergehenden Ansprüche, **dadurch gekennzeichnet, dass** die Siliziumsubstrate (6) im Plasmaätzraum (2) durch eine Substrattemperiervorrichtung (11) temperiert werden.

7. Verfahren nach wenigstens einen der vorhergehenden Ansprüche, **dadurch gekennzeichnet, dass** Siliziumsubstrate (6) kontinuierlich auf einer Substrattransportvorrichtung (4) durch den Plasmaätzraum (2) hindurchgefahren werden.

8. Vorrichtung (1, 1', 1") zum Texturieren wenigstens einer Substratoberfläche (61) wenigstens eines kristallinen Siliziumsubstrates (6) mit einem Plasmaätzraum (2), der eine Gaszuführeinrichtung (7), die mit einer Fluorquelle (8) gekoppelt ist, und wenigstens eine Plasmaquelle (3) aufweist,
**dadurch gekennzeichnet,**
**dass** die Gaszuführeinrichtung (7) außerdem mit wenigstens einer Schwefeloxidquelle (9) gekoppelt ist.

9. Vorrichtung nach Anspruch 8, **dadurch gekennzeichnet, dass** die Fluorquelle (8) ein mit dem Plasmaätzraum (2) gekoppeltes Fluorgasversorgungs und/oder Fluorgaserzeugungssystem ist, in dem Fluor vor dessen Zuleitung in den Plasmaätzraum (2) durch Elektrolyse aus Fluorwasserstoff erzeugbar ist.

10. Vorrichtung nach Anspruch 8 oder 9, **dadurch gekennzeichnet, dass** ein mit der Fluorquelle (8) verbundener Gaseinlass (71) der Gaszuführeinrichtung (7) näher an der Substratoberfläche (61) als ein mit der Schwefeloxidquelle (9) verbundener Gaseinlass (72) der Gaszuführeinrichtung (7) vorgesehen ist.

11. Vorrichtung nach wenigstens einem der Ansprüche 8 bis 10, **dadurch gekennzeichnet, dass** der Plasmaätzraum (2) wenigstens einen Gasauslass (12) aufweist, der in wenigstens eine nasschemische Abgasbehandlungsvorrichtung (13) mündet.

12. Vorrichtung nach wenigstens einem der Ansprüche 8 bis 11, **dadurch gekennzeichnet, dass** die wenigstens eine Plasmaquelle (3) eine Mikrowellenplasmaquelle und/oder eine induktiv gekoppelte Plasmaquelle ist.

13. Vorrichtung nach wenigstens einem der Ansprüche 8 bis 12, **dadurch gekennzeichnet, dass** in dem Plasmaätzraum (2) wenigstens eine Substrattemperiervorrichtung (11) vorgesehen ist.

14. Vorrichtung nach wenigstens einem der Ansprüche 8 bis 13, **dadurch gekennzeichnet, dass** die Vorrichtung (1, 1', 1") eine Durchlaufanlage mit einer den Plasmaätzraum (2) durchfahrenden Substrattransportvorrichtung (4) für das wenigstens eine zu texturierende Siliziumsubstrat (6) ist.

## Claims

1. Method for texturing at least one substrate surface (61) of at least one crystalline silicon substrate (6) by etching the substrate surface (61) with fluorine gas, wherein the etching of the silicon substrate (6) is carried out in a plasma (20), which is produced in a plasma etching room (2),
**characterized in that**
the plasma etching room (2) is supplied with at least gaseous sulfur oxide besides fluorine gas.

2. Method according to claim 1, **characterized in that** the fluorine gas is produced by electrolysis in at least one fluorine gas generating system coupled with the plasma etching room (2) and is supplied into the plasma etching room (2).

3. Method according to claim 1 or 2, **characterized in that** the fluorine gas is introduced closer at the substrate surface (61) into the plasma etching room (2) than the other process gases used in the method.

4. Method according to at least one of the preceding claims, **characterized in that** process gases not used during etching and exhaust gases resulting from etching are discharged from the plasma (20) by at least one gas outlet (12) and are subsequently passed through at least one wet chemical exhaust gas treatment device (13).

5. Method according to at least one of the preceding claims, **characterized in that** the plasma (20) is produced at a frequency in the microwave range and/or by at least one inductively coupled plasma source.

6. Method according to at least one of the preceding claims, **characterized in that** the silicon substrates (6) in the plasma etching room (2) are tempered by a substrate tempering device (11).

7. Method according to at least one of the preceding claims, **characterized in that** silicon substrates (6) are continuously transported on a substrate transport device (4) through the plasma etching room (2).

8. Device (1, 1', 1") for texturing at least one substrate surface (61) of at least one crystalline silicon substrate (6) with a plasma etching room (2), comprising a gas inlet device (7), which is coupled to a fluorine source (8), and at least one plasma source (3),
**characterized in that**
the gas inlet device (7) is additionally coupled with at least one sulfur oxide source (9).

9. Device according to claim 8, **characterized in that** the fluorine source (8) is a fluorine gas supply system and/or fluorine gas generating system, in which fluorine is producible by electrolysis from hydrogen fluoride before its supply into the plasma etching room (2), being coupled to the plasma etching room (2).

10. Device according to claim 8 or 9, **characterized in that** a gas inlet (71) of the gas inlet device (7) connected to the fluorine source (8) is provided closer at the substrate surface (61) than a gas inlet (72) of the gas inlet device (7) connected to the sulfur oxide source (9).

11. Device according to at least one of the claims 8 to 10, **characterized in that** the plasma etching room (2) comprises at least one gas outlet (12), which opens out into at least one wet chemical exhaust gas treatment device (13).

12. Device according to at least one of the claims 8 to 11, **characterized in that** the at least one plasma source (3) is a microwave plasma source and/or an inductively coupled plasma source.

13. Device according to at least one of the claims 8 to 12, **characterized in that** at least one substrate tempering device (11) is provided in the plasma etching room (2).

14. Device according to at least one of the claims 8 to 13, **characterized in that** the device (1, 1', 1") is an inline device with a substrate transport device (4) running through the plasma etching room (2) for the at least one silicon substrate (6) to be textured.

## Revendications

1. Procédé de texturation d'au moins une surface de substrat (61) d'au moins un substrat de silicium cristallin (6) par corrosion de la surface de substrat (61) au moyen de fluor gazeux, la corrosion du substrat de silicium (6) étant effectuée dans un plasma (20) généré dans une chambre de corrosion à plasma (2),
**caractérisé en ce**
**qu'**au moins de l'oxyde de soufre gazeux est amené dans la chambre de corrosion à plasma (2) en plus du fluor gazeux.

2. Procédé selon la revendication 1, **caractérisé en ce que** le fluor gazeux est généré par électrolyse dans au moins un système de génération de fluor gazeux couplé à la chambre de corrosion à plasma (2) et est amené dans la chambre de corrosion à plasma (2).

3. Procédé selon la revendication 1, **caractérisé en ce que** le fluor gazeux est introduit plus près de la surface de substrat (61) dans la chambre de corrosion à plasma (2) que les autres gaz de process utilisés dans le procédé.

4. Procédé selon au moins une des revendications précédentes, **caractérisé en ce que** les gaz de process non consommés lors de la corrosion et les gaz rejetés lors de la corrosion sont déviés hors du plasma (20) via au moins une sortie de gaz (12) et sont ensuite dirigés via au moins un dispositif de traitement chimique humide des gaz rejetés (13).

5. Procédé selon au moins une des revendications précédentes, **caractérisé en ce que** le plasma (20) est généré à une fréquence comprise dans la plage de microondes et/ou par au moins une source de plasma couplée par induction.

6. Procédé selon au moins une des revendications précédentes, **caractérisé en ce que** les substrats de silicium (6) dans la chambre de corrosion à plasma (2) sont tempérés par un dispositif de régulation de température de substrat (11).

7. Procédé selon au moins une des revendications précédentes, **caractérisé en ce que** les substrats de silicium (6) passent en continu au travers de la chambre de corrosion à plasma (2) sur un dispositif de transport de substrat (4).

8. Dispositif (1, 1', 1") de texturation d'au moins une surface de substrat (61) d'au moins un substrat de silicium cristallin (6) avec une chambre de corrosion à plasma (2), qui présente un dispositif d'amenée de gaz (7) qui est couplé à une source de fluor (8), et présente au moins une source de plasma (3),
**caractérisé en ce que**
le dispositif d'amenée de gaz (7) est en outre couplé à au moins une source d'oxyde de soufre (9).

9. Dispositif selon la revendication 8, **caractérisé en ce que** la source de fluor (8) est un système de distribution et/ou génération de fluor gazeux couplé à la chambre de corrosion à plasma (2), dans lequel le fluor peut être généré par électrolyse à partir de fluorure d'hydrogène, avant d'être amené dans la chambre de corrosion à plasma (2).

10. Dispositif selon la revendication 8 ou 9, **caractérisé en ce qu'**une entrée de gaz (71) du dispositif d'amenée de gaz (7), reliée à la source de fluor (8) est prévue plus près de la surface de substrat (61) qu'une entrée de gaz (72) du dispositif d'amenée de gaz (7), reliée à la source d'oxyde de soufre (9).

11. Dispositif selon au moins une des revendications 8 à 10, **caractérisé en ce que** la chambre de corrosion à plasma (2) présente au moins une sortie de gaz (12) qui débouche dans au moins un dispositif de traitement chimique humide des gaz rejetés (13).

12. Dispositif selon au moins une des revendications 8 à 11, **caractérisé en ce que** l'au moins une source de plasma (3) est une source de plasma à microondes et/ou une source de plasma couplée par induction.

13. Dispositif selon au moins une des revendications 8 à 12, **caractérisé en ce qu'**au moins un dispositif de régulation de température de substrat (11) est prévu dans la chambre de corrosion à plasma (2).

14. Dispositif selon au moins une des revendications 8 à 13, **caractérisé en ce que** le dispositif (1, 1', 1") est une chaîne de traitement en continu avec un dispositif de transport de substrat (4) passant au travers de la chambre de corrosion à plasma (2) pour l'au moins un substrat de silicium (6) à texturer.
